(19)

**Europäisches Patentamt**
**European Patent Office**
**Office européen des brevets**

(11) **EP 4 622 110 A1**

(12) **EUROPEAN PATENT APPLICATION**

(43) Date of publication:
24.09.2025 Bulletin 2025/39

(21) Application number: 24165506.7

(22) Date of filing: 22.03.2024

(51) International Patent Classification (IPC):
H03M 1/08 $^{(2006.01)}$     H03M 1/16 $^{(2006.01)}$

(52) Cooperative Patent Classification (CPC):
H03M 1/164; H03M 1/0854; H03M 3/414

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(71) Applicant: NXP B.V.
5656 AG Eindhoven (NL)

(72) Inventors:
• HARDEMAN, Gijsbert Willem
  5656 AG Eindhoven (NL)
• RUTTEN, Robert
  5656 AG Eindhoven (NL)
• LIU, Qilong
  5656 AG Eindhoven (NL)
• BAJORIA, Shagun
  5656 AG Eindhoven (NL)
• BREEMS, Lucien Johannes
  5656 AG Eindhoven (NL)

(74) Representative: Hardingham, Christopher Mark
NXP Semiconductors
Intellectual Property Group
The Cattle Barn
Upper Ashfield Farm, Hoe Lane
Romsey, Hampshire S051 9NJ (GB)

Remarks:
Amended claims in accordance with Rule 137(2) EPC.

(54) **AN APPARATUS INCLUDING A DETECTOR**

(57)     An apparatus for calibrating a digital filter to replicate a transfer function of a signal processing device comprising a detector with a first input to receive a first signal; a second input to receive a response signal of the signal processing device to the first signal; a signal modification block; a comparison block and a decimation block; wherein the comparison-block compares a phase and amplitude of the first signal after a correction has been applied by the signal modification block and decimation has been applied by the decimation block; and a feedback loop; wherein detector is configured to determine at least a feedback control signal at a first frequency and a second frequency, different to the first frequency and determine calibration information for programming of the transfer function of said digital filter.

Fig. 3

EP 4 622 110 A1

**Description**

<u>Field</u>

The present disclosure relates to an apparatus for determining a transfer function of a signal processing device. In one or more examples, it relates to an apparatus including a detector for determining a transfer function of a signal processing device and deriving calibration information to program a digital filter to replicate the transfer function. The present disclosure also relates to a combination of the apparatus and a continuous-time pipelined analog to digital convertor.

<u>Background</u>

A transfer function represents the effect a signal processing device of one or more components has on a signal, such as in terms of its amplitude and/or phase. It may be desirable to measure the transfer function. A digital filter may be programmed to replicate the transfer function of other signal processing components. However, deriving the transfer function such that the digital filter can be programmed in a time-efficient manner is a challenge.

<u>Summary</u>

According to a first aspect of the present disclosure there is provided an apparatus for determining a transfer function of a signal processing device, the apparatus comprising at least one detector comprising:

> a first input configured to receive a first signal;
> a second input configured to receive a response signal comprising a response of the signal processing device to the first signal;
> a signal modification block;
> a comparison block;
> a decimation block;
> wherein the comparison-block comprises a phase comparator and an amplitude comparator, wherein the phase comparator is configured to provide a first output indicative of a phase difference between the first signal, after a correction has been applied by the signal modification block and decimation has been applied by the decimation block, and the response signal and the amplitude comparator is configured to provide a second output indicative of an amplitude difference between the first signal, after a correction has been applied by the signal modification block and decimation has been applied by the decimation block, and the response signal;
> a feedback loop including the signal modification block, wherein the signal modification block is coupled to the first input and the decimation block is coupled in series between the signal modification block and the comparison block and the signal modification block is configured to selectively apply the correction to the first signal, and wherein the feedback loop is configured to, based on the output of the phase comparator and the output of the amplitude comparator, provide a feedback control signal to control the signal modification block to reduce the phase difference indicated by the first output and the amplitude difference indicated by the second output; and
> wherein the at least one detector is configured to determine, at least, the feedback control signal at a first frequency and the feedback control signal at a second frequency, different to the first frequency and, therefrom, determine calibration information representative of the transfer function for programming of a digital filter.

In one or more embodiments the apparatus incudes an interpolation-block, wherein the interpolation-block is configured to interpolate at least between the first frequency and the second frequency to determine the calibration information for programming of the transfer function of said digital filter based on at least a first frequency domain sample, wherein the detector is configured to determine the first frequency domain sample by determining a discrete Fourier transform of the feedback control signal at the first frequency; and a second frequency domain sample, wherein the detector is configured to determine the second frequency domain sample by determining a discrete Fourier transform of the feedback control signal at the second frequency, and wherein the interpolation-block is configured to apply an interpolation algorithm that determines, based on the first frequency domain sample and the second frequency domain sample and by interpolation, the calibration information.

In one or more embodiments the signal processing device comprises a continuous pipeline ADC comprising a first ADC configured to output the response of the signal processing device to the first signal and a second ADC, wherein the second ADC is configured to operate at a sampling frequency Fs and the first ADC is configured to operate at a sampling frequency Fs/N and wherein the decimation block of the apparatus is configured to output a decimated signal at the sampling frequency of the first ADC.

In one or more embodiments N is an integer odd number.

In one or more embodiments the apparatus is configured to provide for generation of the first signal, wherein the first signal comprises a square wave.

In one or more embodiments:

(a) the apparatus is configured to provide for generation of the first signal having a fundamental frequency of Fs/M wherein M > N;

(b) the apparatus is configured to provide for generation of the first signal, comprising a square wave having a fundamental frequency of Fs/M wherein M > N mixed with another square wave of fundamental frequency Fs/P.

In one or more examples P < N and in one or more other examples P > N.

In one or more embodiments the frequencies used to generate the square waves are configured such that harmonics of the square wave do not fold on top of each other when decimated to Fs/N by said decimation block.

In one or more examples, the first signal is configured to be absent of frequency content that overlaps with:

the first frequency when the feedback control signal at the first frequency is determined; and
the second frequency when the feedback control signal at the second frequency is determined;
once decimation has been applied by the decimation block.

In one or more embodiments the at least one detector and interpolation block are configured to:
determine an interpolation between the first and second frequency domain samples or an inverse discrete Fourier transform of the at least first and second frequency domain samples.

In one or more embodiments said at least one detector comprises a first detector and a second detector, wherein the first detector is configured to determine the first frequency domain sample and the second detector is configured to determine the second frequency domain sample in parallel, and wherein the interpolation-block is configured to receive the frequency domain sample from the first detector and the frequency domain sample from the second detector.

In one or more embodiments the signal modification block is a controllable finite-impulse-response, FIR, filter.

In one or more examples, the feedback control signal at the first frequency defines the at least two-taps of the finite-impulse-response filter that replicates the transfer function at the first frequency and the feedback control signal at the second frequency defines the at least two-taps of the finite-impulse-response filter that replicates the transfer function at the second frequency, and wherein the detector is configured to determine the first frequency domain sample by determining a discrete Fourier transform of the feedback control signal at the first frequency and is configured to determine the second frequency domain sample by determining a discrete Fourier transform of the feedback control signal at the second frequency; and

the interpolation-block is configured to apply an interpolation algorithm that determines, based on the first frequency domain sample and the second frequency domain sample and by interpolation, the calibration information, wherein the calibration information represents the transfer function of the signal processing device at the first frequency and the second frequency and the transfer function interpolated therebetween.

In one or more examples the apparatus is configured to determine the feedback control signal at the first frequency and the feedback control signal at the second frequency sequentially.

In one or more examples, the at least one detector includes a controllable mixer arrangement comprising:

a first programmable digital mixer and a first low-pass-filter, wherein the first programmable digital mixer is configured to receive the output of the finite-impulse-response filter, comprising the first signal after the correction has been applied, and a mix signal and wherein the output of the first programmable digital mixer is provided to the comparison-block via the first low-pass-filter; and
a second programmable digital mixer and a second low-pass-filter, wherein the second programmable digital mixer is configured to receive the response signal from the second input and the mix signal and wherein the output of the second programmable digital mixer is provided to the comparison-block via the second low-pass-filter,
wherein the at least one detector is configured to determine, at least, the feedback control signal at the first frequency and the feedback control signal at the second frequency by control of the mix signal by the controllable mixer arrangement.

In one or more examples, the feedback loop includes a first integrator configured to integrate the first output of the phase comparator and a second integrator configured to integrate the second output of the amplitude comparator; wherein the output of the first integrator and the second integrator provide the feedback control signal for the at least two taps of the finite-impulse-response filter such that the feedback loop is configured to drive the input to the first integrator and the second integrator to zero or within a threshold thereof.

In one or more examples, the feedback loop includes a coefficient determination element between the output of the first integrator and the finite-impulse-response filter wherein the coefficient determination element is configured to provide a number of coefficients for setting of the at least two taps of the finite-impulse-response filter.

In one or more examples, one or both of the first integrator and the second integrator are configurable to be initialized with an initial value when determining the feedback control signal at the second frequency, the initial value based on the feedback control signal at the first frequency determined when the feedback loop has driven the input to the first integrator and the second integrator to zero or within a threshold thereof; or wherein the gain of one or both of the first integrator and the second integrator is configurable.

In one or more examples, the phase comparator is configured to determine and therefore output as the first output one of:

a cross-product of the first signal of the output of the first low-pass-filter and the output of the second low-pass-filter or respective signals derived therefrom; and
a phase angle difference between the output of the first low-pass-filter and the output of the second low-pass-filter divided by the product of the amplitudes of the output of the first low-pass-filter and the output of the second low-pass-filter;

a cross product, divided by the product of the magnitude of the of the output of the first low-pass-filter and the magnitude of the output of the second low-pass-fi lter.

In one or more examples, the at least one detector is configured to provide the first signal; store the feedback control signal at the first frequency or the first frequency domain sample at a time when the feedback loop has caused the phase difference and the amplitude difference to be less than a predetermined threshold; and store the feedback control signal at the second frequency or the second frequency domain sample at a time when the feedback loop has caused the phase difference and the amplitude difference to be less than a further predetermined threshold.

According to a second aspect of the present disclosure there is provided a combination of the apparatus of any preceding claim and a continuous-time, pipeline ADC, CT-P-ADC, wherein the CT-P-ADC comprises the digital filter, and the signal processing device comprises at least part of the CT-P-ADC, and the CT-P-ADC or apparatus is configured to program the digital filter based on the calibration information.

In one or more embodiments the CT-P-ADC comprises a time interleaving backend. In one or more examples, the CT-P-ADC comprises a time interleaving backend comprising a plurality of selectable ADCs in parallel wherein one of:

(a) each of the plurality of ADCs has adjustable gain and bandwidth and wherein determination of the calibration information includes the combination being configured to determine gain and bandwidth mismatch differences between each of the plurality of ADCs and provide for adjustment of the adjustable gain and bandwidth to remove the mismatch; and
(b) wherein the determination of the calibration information includes the combination being configured to determine calibration information for each of the plurality of ADCs for programming of a respective a digital filter for each of the plurality of ADCs.

In one or more embodiments the CT-P-ADC comprises:

a CT-P-ADC input to receive an analogue signal,
a branch node configured to provide the analogue signal to a first path and a second path,
wherein the first path comprises at least a continuous time all-pass filter, CTAPF; a difference block having a first input configured to receive the output of the CTAPF and a second input, and configured to output a difference between signals at the first input and the second input; an amplifier configured to receive the output of the difference block and provide an output; a low-pass-filter configured to receive the output of the amplifier and provide an output; and a, first ADC configured to receive the output of the low-pass-filter and provide the response signal to the second input;

wherein the second path comprises a second ADC configured to receive the analogue signal via the branch node and the digital filter configured to receive the output of the second ADC and a second decimation block;
wherein the CT-P-ADC comprises a summation block configured to provide an output of the CT-P-ADC based on a summation of the output of the first ADC from the first path and the output of the second decimation block of the second path;

wherein the CT-P-ADC comprises a first DAC configured to receive the output of the second ADC and provide a digitised output to the second input of the difference block.

In one or more examples, the digital filter comprises a polyphase filter.

According to a third aspect of the present disclosure there is provided a method for an apparatus for determining a transfer function of a signal processing device, the apparatus comprising at least one detector comprising a signal modification block; a comparison block; and a decimation block for performing the method of:

receiving, at a first input, a first signal;

receiving, at a second input, a response signal comprising a response of the signal processing device to the first signal;

making a comparison by a comparison-block comprising one or both of a phase comparator and an amplitude comparator, of one or both of the phase and amplitude of the first signal and the response signal;

outputting, by the phase comparator, a first output indicative of a phase difference between the first signal after correction applied by the signal modification block and decimation applied by the decimation block, and the response signal;

outputting, by the amplitude comparator, a second output indicative of an amplitude difference between the first signal after correction applied by the signal modification block and decimation applied by the decimation block, and the response signal;

providing feedback, wherein a feedback loop including the signal modification block and the decimation block, and wherein the signal modification block is coupled to the first input and the decimation block is coupled in series between the signal modification block and the comparison block, is configured to, based on the output of the phase comparator and the output of the amplitude comparator, generate a feedback control signal to control the signal modification block to reduce the phase difference indicated by the first output and the amplitude difference indicated by the second output; and

determining, at least, the feedback control signal at a first frequency and the feedback control signal at a second frequency, different to the first frequency.

## Brief Description of the Drawings

One or more embodiments will now be described by way of example only with reference to the accompanying drawings in which:

Figure 1 shows an example embodiment of a continuous-time pipelined analog to digital convertor;

Figure 2 shows the example embodiment of the continuous-time pipelined analog to digital convertor with a first signal, which may comprise a test signal, applied thereto;

Figure 3 shows a first example embodiment of a detector;

Figure 4 shows a second, more detailed embodiment of the detector;

Figure 5 shows a flowchart illustrating an example method;

Figure 6 shows a continuous-time pipelined analog to digital convertor having a time interleaving backend;

Figure 7 shows the example embodiment of Figure 6 with a first signal, which may comprise a test signal, applied thereto.

## Detailed Description

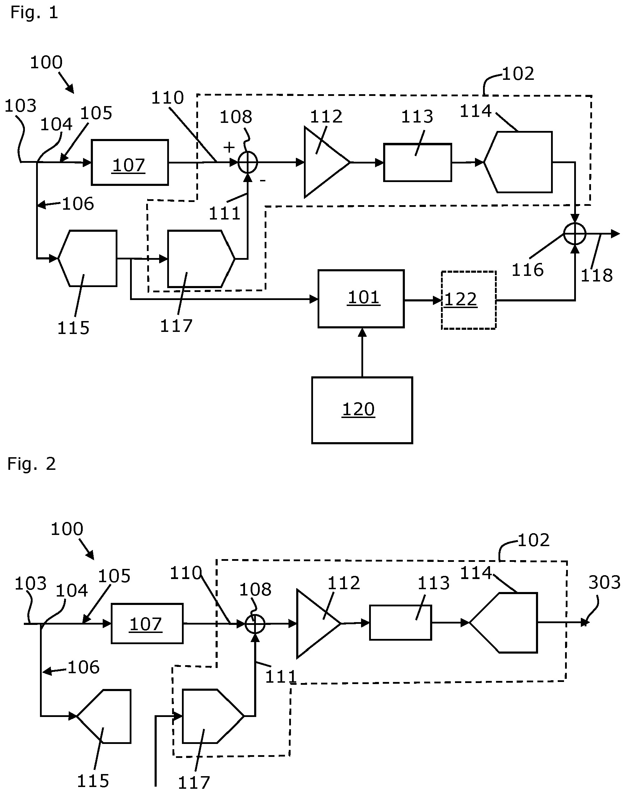

The present disclosure relates to an apparatus for determining a transfer function of a signal processing device. Once the transfer function or a representation of the transfer function has been determined, it can be used for calibrating or programming a digital filter. The apparatus comprises a detector 120, 301, shown in Figure 1 and figures 3 and 4. The detector is for determining the transfer function of the signal processing device. The signal processing device comprises one or more digital and/or analogue components through which a signal is passed. In one or more examples, that will be described later, the detector may be configured to derive calibration information to program the digital filter to replicate the transfer function of the signal processing device it has determined. The transfer function may be indicative of the phase shift and/or amplitude change induced by the one or more components of the signal processing device for one or more frequencies or over a predetermined range of frequencies.

With reference to Figure 1, we describe a continuous-time pipelined analog to digital convertor, CT-P-ADC 100. The CT-P-ADC 100 comprises one example of many where the efficient replication of a transfer function by a digital filter is particularly advantageous. However, it should be understood that the present disclosure is not limited to the use of the detector in combination with the continuous-time pipelined analog to digital convertor. Other example combinations include use of the detector with a multistage noise shaping (MASH) sigma-delta data converter.

Before we describe the detector, we will describe an example use-case with reference to the CT-P-ADC 100 of Figure 1.

In general, the CT-P-ADC 100 comprises a digital filter 101, and a signal processing device 102 and the programming of the digital filter 101 is based on calibration information derived by the detector described later.

The CT-P-ADC 100 comprises a CT-P-ADC input 103 configured to receive an analogue signal for conversion to a digital signal by the CT-P-ADC 100. The CT-P-ADC 100 comprises two branches and a branch node 104 is configured to split the analogue signal and provide it to a first path 105 and a second path 106.

The first path 105 includes a continuous time all-pass filter, CTAPF, 107. In other examples, the CTAPF 107 may be replaced by a delay element.

The first branch 105 further comprises a difference block 108 having a first input 110 configured to receive the output of the CTAPF 107 and a second input 111. The difference block 108 is configured to output a difference between signals at the first input 110 and the second input 111.

The first path 105 further comprises an amplifier 112 configured to receive the output of the difference block 108 and provide an amplified output. A low-pass-filter 113 is configured to receive the output of the amplifier 112 and provide a filtered output. It will be appreciated that the components of the first path 105 may be presented in a different order in other examples.

The first path 105 further comprises a first ADC 114, sometimes referred to as a "back-end ADC" or "fine ADC" by those skilled in the art, configured to receive the output of the low-pass-filter 113.

The second path 106 comprises a second ADC 115, sometimes referred to as a "front-end ADC" or "coarse ADC" by those skilled in the art, configured to receive the analogue signal via the branch node 104. The digital output of the second ADC 115 is received by the digital filter 101. The digital filter 101 may be known as a reconstruction filter in the art of CT-P-ADCs.

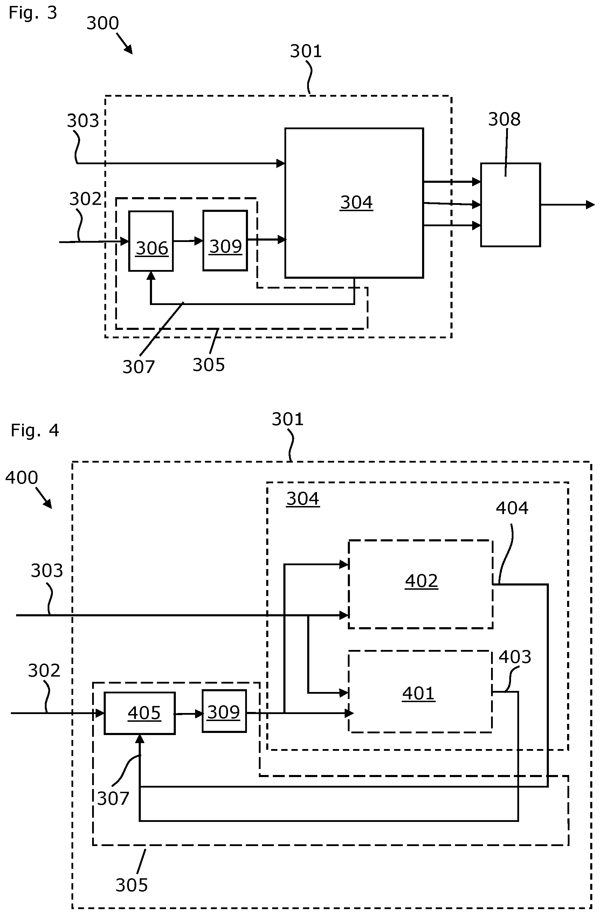

In the examples of the present disclosure, the first ADC 114 operates at a reduced sampling rate compared to the second ADC 115. Thus, Figure 1 shows an example CT-P-ADC 100 that is configured to enable the first ADC 114 to operate at the reduced sampling rate compared to the second ADC 115 using calibration information obtained by the detector 120. Likewise, Figures 3 and 4 described later, disclose the detector 301 being configured to account for the first ADC 114 operating at the reduced sampling rate compared to the second ADC 115.

In the present example, the second ADC 115 may have a sampling rate of $F_s$ and the first ADC 114 may have a sampling rate of $F_s/N$, where N is an integer.

Solely for understanding, the first ADC 114 can be modelled as an ADC running at $F_s$, followed by a decimation (e.g. downsampling) of factor 1/N representing the reduction in sampling rate relative to the second ADC 115. In order to match the sampling rate in the first path 105, a decimation block 122 is provided after the digital filter 101 in the second path 106. In some examples, the digital filter 101 can be implemented as a polyphase filter for power saving, in that case block 101 and block 122 are merged.

The first path 105 and second path 106 merge at a summation block 116. As will be understood, the output of the summation block 116 comprises the output of the CT-P-ADC 100 and comprises a summation of the signal from the first and second paths 105, 106. Thus, the output comprises a summation of the output of the first ADC 114 of the first path 105 and the output of the digital filter 101 having been decimated by the decimation block 122 of the second path 106.

Further, the CT-P-ADC 100 comprises a first DAC 117 configured to receive the digital output of the second ADC 115 and provide an analogue output to the second input 111 of the difference block 108. Thus, the difference block 108 is configured to determine the difference between the analogue signal as delayed by the CTAPF 107 and the output of the second ADC 115, as converted to analogue again by the DAC 117. The delay provided by the CTAPF 107 is configured to match the delay introduced by the second ADC 115 and the first DAC 117.

The operation of the CT-P-ADC 100 will not be described here in detail as it is not relevant for the purpose of understanding the disclosure. However, as will be understood by those skilled in the art of CT-P-ADCs, the transfer function of the digital filter 101 and the second decimation block 122 should match, at least over a predetermined range of frequencies, the transfer function of the first DAC 117, the difference block 108, the amplifier 112, the low-pass filter 113 and the first ADC 114 (collectively, and more generally, referred to as the signal processing device 102).

Thus, when the transfer function is matched, the summation, at summation block 116, of the output of the first ADC 114 and output of the filter 101 and the second decimation block 122 results in the cancellation of the quantization noise of the second ADC 115 in the final output at 118.

It will be appreciated that the CT-P-ADC 100 may comprise a plurality of stages in the first path and therefore the signal processing device 102 may comprise the first DAC 117, the difference block 108, the amplifier 112, the low-pass filter 113 and the first ADC 114 and then a second stage in series with a further first DAC, difference block, amplifier, low-pass filter and first ADC. In other examples the detector may be configured to determine the transfer function of all of the stages collectively or each stage separately. Thus, in some examples there may be provided a digital filter and the second decimation block 122 in the second path for each stage which will be in need of programming by the detector described later.

It has been found that the use of a lower sampling rate in the first ADC 114 causes out-of-band (OOB) noise folding to in-band. This folding or aliasing as is known to the person skilled in the art is due to sampling an analog signal at a frequency below the Nyquist frequency. The folding can be replicated in the digital domain and cancelled at the output of the CT-P-ADC if the digital filter 101 matches the transfer function of the signal processing device 102 in in-band, as well as the regions of the spectrum that fold back in-band. However, it has been found that the folding has to happen in both the analog and digital domain in the same way, for the folded noise to be cancelled. Therefore, in the embodiment of figure 1 and figure 2, it is desirable that the transfer function from the output of the second ADC 115 to the output of the first ADC 114 is substantially the same as the output of the decimation block 122, at least over a predetermined range of frequencies at which the CT-P-ADC 100 operates.

The output of the second ADC 115 consists of the input signal 103 plus a wideband quantization noise floor. If the first ADC 114 runs at $F_s$, it will measure the noise floor after it has been low-pass filtered. When the first ADC 114 runs at $F_s/N$, as in the present embodiment, the part of the noise floor that is close to $F_s/N$ will fold back to in band. In order to cancel the folded noise, it has been found that the digital filter 101 should apply the same transfer function to the quantization noise, over the whole band. If N=3 then also signal content around 2*(Fs/3) will fold back, which needs to be cancelled. Consequently, the transfer function of signal processing device 102 may be characterized at frequencies that include 2*(Fs/3), which is higher than the sample rate of the first ADC 114 in this example. After decimating the output of the digital filter 101 by the decimation block 122, it can be summed with the output of the first ADC 114 at the summation block 116, thereby cancelling the in-band as well as the OOB noise.

Returning to the detector 120, its purpose may be to determine calibration information and, optionally, program the digital filter 101. Although not shown in figure 1, the detector 120 is coupled to the signal processing device 102 in order to measure the transfer function over a predetermined range of frequencies to determine the calibration information for use in programming the digital filter 101. It will be appreciated that the calibration information may define the transfer function of the signal processing device 102 or an approximation thereof over a predetermined range of frequencies. Alternatively, the calibration information may take the form of a plurality of parameters, such as tap values, for programming the digital filter 101. Whichever form the calibration information takes, it may be suitable for programming the digital filter 101 to filter the signal in the second path 106 in a way that replicates the transfer function of the signal processing device 102 to within a predetermined accuracy.

In the one or more of the present examples, the detector 120 is configured to generate calibration information for the digital filter 101 and is implemented with sufficiently low complexity and power while maintaining enough accuracy to guarantee the system performance. In one or more examples, the CT-P-ADC may be used for a radar application which, by use of the detector 120, allows for quick re-calibration in between consecutive radar cycles.

In one or more examples, the combination of the CT-P-ADC 100 and the detector 120 may be configured to operate in a calibration-information-determination mode, wherein a first signal, which may be a test signal, is applied to the signal processing device 102 and the detector 120 is configured to determine the transfer function to derive calibration information. The digital filter 101 may then be programmed. In one or more examples, the combination may also operate in a normal mode in which the CT-P-ADC 100 is provided with an analogue input signal and is configured to provide a digital signal representing said analogue input signal at the output 118 and the detector 120 is inactive.

Figure 2 shows part of the CT-P-ADC 100 and provides an example in which the test signal is applied. The same reference numerals have been used for like parts. Thus, when operating in the calibration-information-determination mode, the test signal is applied to the input of the first DAC 117. Therefore, this disclosure proposes a foreground calibration where no analogue signal is applied during the calibration-information-determination mode. In the present example, the test signal is applied to the first DAC 117 that is used as part of the CT-P-ADC 100 but, in other examples, the test signal may be applied via an auxiliary DAC (not shown) that outputs an analogue version of the test signal to the difference block 108 or the amplifier 112.

In some examples, the first signal or "test signal" may comprise one of: white noise; coloured noise; square waves; tones and one or more sine waves. In one or more preferred examples, the test signal may be set to one of a plurality of different predetermined frequencies or tones. The transfer function can then be measured. Then, setting the test signal to a different one of the plurality of frequencies or tones enables the detector 120 to characterise the transfer function at the different frequency or frequencies. In other examples, the test signal may be unaltered during operation of the apparatus 100 in the calibration-information-determination mode and other means may be provided to adjust the frequency evaluated by the detector.

When running the first ADC 114 at $F_s/N$, the response to a wideband test-signal can only be observed at $F_s/N$ and the measured response to a wideband test signal will have multiple frequencies folded on top of each other as described previously. The aliasing in the first ADC 114 results in frequency components folding on top thus compromising the calibration accuracy. The proposed solution is to use test signals that avoid information destroying folding, such as single tones or square waves with predetermined frequencies, which will be described in relation to figure 3.

Figure 3 shows an example of the detector 300. Figure 4 shows a more detailed example of the detector 400. The following description makes reference to both embodiments. The detector comprises, in the present example, one detector 301 that is configured to operate sequentially to determine the transfer function at a plurality of predetermined frequencies or tones. In other examples, the apparatus may comprises a plurality of detectors each configured to determine the transfer function at a different one of the plurality of predetermined frequencies or tones in parallel.

The detector 301 comprises a first input 302 configured to receive a first signal. A second input 303 of the detector 301 is configured to receive a response signal comprising the response of the signal processing device 102 (or other components) to the first signal, which may be applied via the first DAC 117 as described above.

The detector 301 further comprises a comparison-block 304 comprising one or both of a phase comparator 401 and an amplitude comparator 402 (shown in the example of figure 4 but not shown in Figure 3). The detector 301 further includes a signal modification block 306 and a decimation block 309.

The phase comparator 401 is configured to provide a first output (at output 403 in figure 4) indicative of a phase difference between the first signal and the response signal. The amplitude comparator 402 is configured to provide a second output (at output 404 in figure 4) indicative of an amplitude difference between the first signal and the response signal.

The detector 301 further comprises a feedback loop 305 configured to modify, by signal modification block 306 (in the example of figure 3) or finite-impulse-response filter 405 (in the example of figure 4) the test signal provided to the first input 302 to reduce any phase difference and/or amplitude difference detected by the comparison-block 304 and, in particular, the phase comparator 401 and the amplitude comparator 402 thereof. The configuration of the signal modification block 306 or finite-impulse-response filter 405 is thereby indicative of the transfer function of the signal processing device 102 at a particular frequency.

The signal modification block 306 (in the example of figure 3) or finite-impulse-response filter 405 (in the example of figure 4) are coupled between the first input 302 and the comparison block 304, or phase comparator 401 and amplitude comparator 402.

The feedback loop 305 is configured to, based on the output of the phase comparator 401 and the output of the amplitude comparator 402, provide a feedback control signal shown at 307 to control the signal modification block 306 or the (e.g. two) taps of the FIR filter 405 to reduce the phase difference indicated by the first output 403 and the amplitude difference indicated by the second output 404. The phase difference and the amplitude difference are determined by the comparison block 304 after a correction has been applied by the signal modification block 306 and after the decimation has been applied by the decimation block 309.

In one or more embodiments, the decimation block 309 of the apparatus is configured to output a decimated signal at the sampling frequency of the first ADC 114. Thus, the decimation block 309 is configured to apply a decimation (e.g. down sampling) by the same factor $1/N$ as the difference in sampling rate between the first ADC 114 and the second ADC 115.

In the example of figure 3, the detector 301 is configured to characterise the transfer function of the signal processing device 102 when the first ADC 114 operates at a reduced sampling frequency of $F_s/N$. In this embodiment, the output of the signal modification block 306 is provided to the decimation block 309 before being provided to the comparison block 304. This ensures that the two inputs to the comparison block 304 are provided at the same sampling rate (i.e. $F_s/N$). Thus, in this embodiment the signal modification block 306 operates at $F_s$, but its coefficients are updated (i.e. controlled by the comparison block 304/feedback loop 305) at a rate of $F_s/N$.

In the present examples, the first signal or test signal received at the first input 302 and also applied to the signal processing device 102, comprises a signal with content at one or more specific frequencies of interest, single tones or signals containing multiple tones, under the condition that no two or more tones fold to the same frequency of interest after decimation. It has been found that using a test signal of this form can overcome data loss due to folding which may be experience when using a wideband test signal due to aliasing.

In one or more embodiments, the detector 120, 301 operates with test signal comprising a tone at a first frequency, F1. F1 is a tone that lies in-band and below the Nyquist frequency of the first ADC 114 sampling at $F_s/N$ (i.e. $F1 < F_s/2N$). When sampling at $F_s$ the response will still have the same tone, the spectrum will be asymmetric about $F_s/2$ and periodic in $F_s$. When sampled at $F_s/N$, the spectrum is asymmetric in $F_s/2N$ and periodic in $F_s/N$. No information is lost because there is no frequency content at frequencies that would fold on top of F1 when decimating with a factor of $1/N$. The test signal and the response can then be compared effectively to find the transfer function at the frequency of F1 applied to the signal processing device 102.

In one or more embodiments, the detector 120, 301 is then configured to operate with the test signal comprising a tone at a second frequency F2, where F2 is higher than $F_s/N$ and can therefore provide for out of band matching of the digital filter 101. The tone at F2 will be filtered by the low pass filter of the signal processing device 102 and therefore will become weaker when the response is measured at $F_s/N$. The response at $F_s/N$ will fold back to the position of $F2-F_s/N$ in the frequency spectrum. The spectrum will be periodic in $F_s/N$. Note that the aliasing due to the first ADC 114 will not lead to information loss as there is no content at frequencies that fold back to the same location before aliasing. Therefore, the content at $F2-F_s/N$ after aliasing is entirely caused by the tone at F2 folding back.

In the present example, the feedback control signal at the two frequencies F1 and F2 is not determined at the same time. In another example a response signal could have signal content at F1 and F3, wherein the transfer function at both F1 and F3 (F3 > Fs/N) could be calibrated using the same response signal, by using a frequency selection inside block 304, under the condition that F3 does not fold to the same location as F1. Calibrating at F1 (which is at a frequency lower than the Nyquist frequency) ensures there is no aliasing when the response signal is sampled by the first ADC 114 operating at $F_s/N$. Calibrating at the higher frequency F2, where F2 is higher than $F_s/N$ leads to aliasing of the sampled response signal. This aliasing added by block 309 is intentional, to replicate the aliasing that also happens in the signal processing device 102. It will be appreciated that the signal processing device 102 can be decomposed to a filtering function at Fs, followed by a decimation with a factor N. Block 405 implements the filtering function at a specific frequency, and block 309 implements the decimation, such that the combined path of block 405 and block 309 replicate the signal processing block 102. Both signals provided to the comparison block 304 are at $F_s/N$. In the examples disclosed herein N is an integer.

Further tones, e.g. F3, F4, F5 may be used to further determine the transfer function. In one or more examples, the detector 301 may be configured to determine the calibration information using at least one or at least two tones below $F_s/2N$ and at least one or at least two tones greater than $F_s/2N$.

The finite-impulse-response filter 405 in the present example has two taps. However, in other examples it may have at least two taps or at least three taps or one tap.

The detector 301 may further comprises an interpolation-block 308 (only shown in Figure 3), which may provide an algorithm that interpolates to determine the transfer function over a range of frequencies based on the feedback control signals at at least two different frequencies, e.g. F1, F2, F3 etc.

Thus, the at least one detector 301 is configured to determine, at least, the feedback control signal at a first frequency (e.g. F1) and the feedback control signal at a second frequency (e.g. F2), different to the first frequency. In other examples, the feedback control signals are determined at further frequencies, such as at least three different frequencies or at least four.

In some examples, a frequency selection block (not shown) can be provided for control of the frequency of the first signal to provide the first frequency and the second frequency.

The interpolation-block 308 is configured to interpolate the feedback control signals at least between the first frequency and the second frequency. Thus, the interpolation-block takes the feedback control signals that represent the transfer function at discrete frequencies and, by interpolation, may generate information indicative of a continuous transfer function over a range of frequencies. In some examples the block 405 consists of a FIR filter. The transfer of this filter could be obtained by calculating a discrete time Fourier transform off the FIR's impulse response at the frequency of interest, thereby obtaining a frequency domain sample of the transfer function of signal processing block 102. The transfer function that is generated or, put another way, the interpolated feedback control signals, are used to determine calibration information for control of the transfer function of said digital filter 101. The interpolation, in general, is based on an inverse Fourier transform of a function of at least the feedback control signal at the first frequency and the feedback control signal at the second frequency.

Thus, after the interpolation, the calibration information may represent a continuous transfer function at least between at least the first frequency and the second frequency that replicates the transfer function of the signal processing device.

The calibration using tones of specific frequencies converges faster and reaches higher accuracy than using a wideband signal such as white noise or using a signal with randomised noise such as dither. This is because the power of the test-signal using tones of specific frequencies is centred at the frequency of interest.

In some embodiments the test signal may be provided by the DAC 117. In such an embodiment it is not possible to generate a pure single tone signal using 1-bit signalling which is provided by the LSB of the output of the DAC 117. Using 2 LSBs of the DAC 117 would lead to clipping during calibration since the amplifier 112 gain is set by the requirement to amplify a residue of $\pm$LSB/2 during normal operation.

In some embodiments, where the test signal is provided by the DAC 117, instead of a test signal being at a particular frequency (i.e. F1 and F2), the first signal (i.e. the test signal) may be a square-wave. This is because a square-wave can be accurately represented by control of the LSB of the DAC 117. In such an embodiment, the frequencies of the square-wave are chosen such that the harmonics of the square-wave do not fold on top of each other when decimating to $F_s/N$ by the backend first ADC 114, as well as in block 309. For this purpose, it is convenient if N is an odd number. In some examples N can be three. However, the disclosure is not limited to N being odd or three.

In some embodiments the apparatus is configured to provide for generation of the first signal being a square wave having a fundamental frequency of $F_s/M$ wherein M > N.

In some specific examples a square wave can be used which has a fundamental frequency of $F_s/64$ that can be used to sample the frequency domain transfer when using a first ADC 114 running at $F_s/3$. All the tones within this test signal can be used to take 16 frequency domain samples of the signal processing device 102.

In some specific examples, the time-domain and frequency domain waveforms of the test signal can be decimated by a factor of 3. The decimated frequency domain spectrum of the square wave test signal contains the same number of distinguishable harmonics as can be observed before decimation. The folded harmonics can therefore still be used for calibration because the original location before folding is known and the decimation only happens as the last step in the signal processing device 102 chain.

It will be appreciated that harmonics at higher frequencies are weaker than the lower frequency harmonics. In some examples the higher frequency harmonics may be about 25dB weaker than the harmonics at low frequencies. This can translate into reduced calibration accuracy at high frequencies. As stated previously, calibration can be performed at two different frequencies F1 and F2, where F2 is higher than F1. The use of high frequency test tones (i.e. at F2) could be used to improve calibration accuracy at higher frequencies as described previously.

In some embodiments, to improve the calibration at high frequencies the apparatus may be configured to provide for generation of the first signal, comprising a square wave having a fundamental frequency of $F_s/M$ wherein $M > N$ mixed with another square wave of $F_s/P$. In some examples $P < N$ and in one or more other examples $P > N$.

In some examples a test-signal consisting of a square wave with fundamental frequency $F_s/64$ mixed with a square wave with fundamental frequency $F_s/2$. The mixing of a square wave with fundamental frequency $F_s/2$ causes the harmonics to be shuffled such that the high harmonics now contain most of the power, resulting in improved OOB calibration accuracy. Similarly, mixing can be performed with a square waveform of fundamental frequency $F_s/4$, to emphasize the middle of the band. The same test signals can also be generated using any kind of frequency synthesizer. Mixing frequencies in such a manner to place the strongest harmonic at a frequency band of interest will be known to a person skilled in the art and will not be described in detail.

In the present examples, the first signal comprises a test signal. However, in other examples, as mentioned briefly above, the calibration information may be determined during normal use. Thus, the signal processing device may be receiving its normal, in-use, signals and the calibration information may be determined. It will be appreciated however that the normal signal, in-use, signals must have frequency components at the first frequency and the second frequency. Alternatively, the normal, in-use, signal must comprise a signal having frequency components at the at least first frequency at a first time and frequency components at the second frequency at a second, different time such that the feedback control signals can be determined sequentially.

Thus, the calibration information may be determined using a test signal, normal in-use signals, or a test signal added on top of the normal in-use signals.

The operation of the detector 120 when using a test signal comprising tones will be briefly described below:
The operation of the amplitude comparator 402 is relatively straightforward - the absolute values of both outputs from a controllable mixer arrangement are determined and are subtracted and provided at output 404.

The phase comparator 401 may operate based on a cross-product of the first signal and the response signal or respective signals derived therefrom as is known to the person skilled in the art. In some examples the phase comparator may operate based on a cross product, divided by the product of the magnitude of the first signal and the magnitude of the second signal.

In general, the feedback loop 305 may be operated for a predetermined time to allow the feedback control signal to converge on a value, upon which the calibration information will be based.

The interpolation-block 308 (only shown in Figure 3) is configured to apply an interpolation algorithm to determine the calibration information that represents the transfer function for the digital filter 101. The interpolation algorithm operates on the frequency domain samples taken at the first frequency and the second frequency and any other frequencies.

In general, once sufficient frequency domain samples have been found. The interpolation-block 308 provides the interpolation algorithm. The interpolation algorithm is described in US 10, 447, 523 B2 but will be summarised here. The interpolation algorithm may be viewed as an interpolation of the frequency domain with complex exponentials as interpolation/basis functions. As any digital filter has a periodic transfer function, it is logical to use periodic functions as basis for the interpolation. The problem to be solved is to find the scaling coefficients for the interpolation functions, wherein these scaling coefficients correspond to the coefficients of the digital filter 101. Below, the relation between the frequency domain samples (termed Vector $X_k$), the impulse response of the final reconstruction filter (termed Vector $x_n$) and the interpolation functions is shown. As the digital filter 101 may be a FIR filter, the impulse response is equal to its coefficients. N is equal to the length of $x_n$ and $F_{mix}$ is a vector consisting of the frequencies of the frequency domain samples. $X_k$, Fmix and $x_n$ need to be of the same length. The vector with the frequencies is referred to as $F_{mix}$ because it also corresponds to the mixing frequency $\omega_{mix}$ within the detector 400 when a frequency domain sample is found.

$$X_k = \sum_{n=0}^{N-1} x_n \cdot e^{-j2\pi\left(\frac{F_{mix}(n)}{F_s}\right)k}$$

The relation can also be written explicitly in matrix form.

$$X_k = [x(0), x(1), x(2). \ldots, x(N-1)] \cdot exp(-j2\pi \frac{1}{F_s} \left\{ \begin{bmatrix} [0 \cdot F_{mix}(0), 1 \cdot F_{mix}(0), \ldots, (N-1) \cdot F_{mix}(0)]; \\ [0 \cdot F_{mix}(1), 1 \cdot F_{mix}(1), \ldots, (N-1) \cdot F_{mix}(1)]; \\ \vdots \qquad \vdots \qquad \vdots \\ [0 \cdot F_{mix}(N-1), 1 \cdot F_{mix}(N-1), \ldots, (N-1) \cdot F_{mix}(N-1)] \end{bmatrix} \right\})$$

Where $X_k$ represents the transfer function of the analog signal processing system 102 at the frequency domain samples, at the frequency locations given by the vector $F_{mix}$.

$$X_k = [H\{Fmix(0)\}, H\{Fmix(1)\}, H\{Fmix(2)\} \ldots, H\{Fmix(N-1)\}]$$

More compactly:

$$X_k = x \cdot A$$

Where A is a matrix is formed of the interpolation basis functions.
This relation is then used to find the transfer function for the digital filter 101:

$$x = X_k \cdot A^{-1}$$

Note that $A^{-1}$ only depends on the frequencies where the frequency domain samples are taken. Consequently, once the frequencies are known, any update to the digital filter 101 only requires a single matrix multiplication. The digital filter 101 may have a linear relation with the frequency domain samples.
In a further example, it can be noted that when the $F_{mix}$ is defined as follows:

$$Fmix = \frac{F_s}{N} \cdot [0, 1, 2, 3. \ldots, N-1]$$

The interpolation algorithm reduces to an Inverse-Discrete-Fourier-Transform(IDFT).
To explain further, the definition of the Discrete-Fourier-Transform(DFT) is shown below.

$$X_k = \sum_{n=0}^{N-1} x_n \cdot e^{-j2\pi(\frac{n}{N})k}$$

When using equidistant frequency domain samples:

$$\frac{n}{N} = \frac{F_{mix}(n)}{F_s}$$

Consequently, the IDFT can be viewed as a special case of the proposed interpolation algorithm. However, the previous example of the interpolation algorithm provides greater flexibility in the location of the frequency domain samples. Though, the impact of a choice of the vector $F_{mix}$ on the quality of the interpolation has to be taken into account.
The interpolation algorithm results in a digital filter 101 that matches perfectly at predetermined locations and interpolates in between.
It will be appreciated that, in other embodiments, the interpolation algorithm may take different forms to map the frequency domain samples to a digital filter 101, such as a least squares method that puts less emphasis on the matching at the predetermined locations but can reach improved matching outside of the predetermined locations.

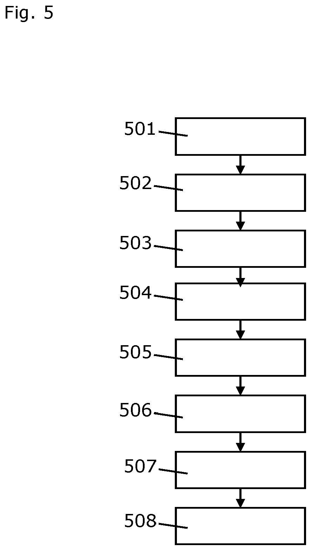

Figure 5 shows an example method for performing by an apparatus for determining a transfer function of a signal processing device, which may be for deriving calibration information for use in calibrating a digital filter to replicate a transfer function of the signal processing device, the apparatus comprising at least one detector comprising a signal modification block; a comparison block; and a decimation block, the method comprising:

> receiving 501, at a first input, a first signal;
> receiving 502, at a second input, a response signal comprising a response of the signal processing device to the first signal;
> making 503 a comparison by a comparison-block comprising one or both of a phase comparator and an amplitude comparator, of one or both of the phase and amplitude of the first signal and the response signal;
> outputting 504, by the phase comparator, a first output indicative of a phase difference between the first signal after correction has been applied by the signal modification block and decimation has been applied by the decimation block and the response signal;
> outputting 505, by the amplitude comparator, a second output indicative of an amplitude difference between the first signal after correction has been applied by the signal modification block and decimation has been applied by the decimation block and the response signal;
> providing feedback 506, by a feedback loop including the signal modification block and the decimation block, wherein the signal modification block is coupled to the first input and the decimation block is coupled in series between the signal modification block and the comparison block, wherein, based on the output of the phase comparator and the output of the amplitude comparator, generating a feedback control signal to control the signal modification block to reduce the phase difference indicated by the first output and the amplitude difference indicated by the second output; and
> determining 507, at least, the feedback control signal at a first frequency and the feedback control signal at a second frequency, different to the first frequency.

In one or more embodiments the method further includes:
interpolating 508, by the interpolation-block, between the first frequency and the second frequency to determine calibration information for control of the transfer function of said digital filter, or otherwise determining the calibration information from the feedback control signal at the first frequency and the feedback control signal at the second frequency.

In a further example, the CT-P-ADC 100 and the detector 100 are provided in combination and may comprise part of a radar device.

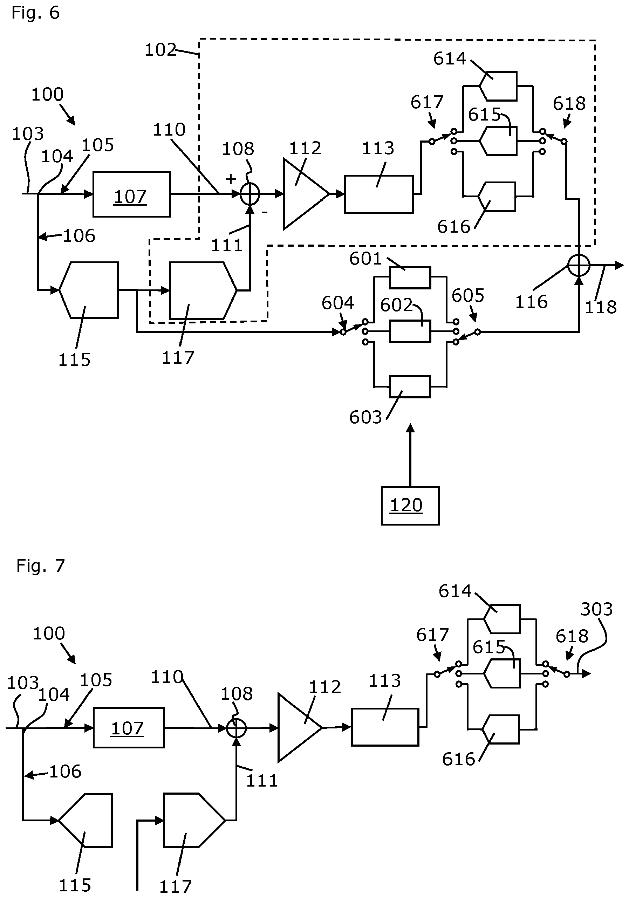

Figures 6 and 7 show an example in which the apparatus 120, 300 is applied for determining a transfer function of a continuous-time pipelined analog to digital convertor, CT-P-ADC 100 having a time interleaving backend. The same reference numerals of Figures 1 and 2 have been used in Figures 6 and 7 for ease of reference. Therefore, only the differences will be described, although it will be appreciated that those skilled in the art of CT-P-ADCs will, in general, be familiar with CT-P-ADCs having a time-interleaved back-end. In the example of Figure 6, the first ADC 114 is replaced with multiple ADCs 614, 615, 616 in parallel with a first interleaver 617 and a first de-interleaver 618 providing the selective connection to the remainder of the circuity. The time interleaving backend may comprise multiple (e.g. N) parallel ADCs, each running at a speed of Fs/N, with different phases. In some examples the interleaver 617 comprises parallel track and hold devices, sampling at different phases.

Figure 7, similar to Figure 2, shows the test signal being applied to the first DAC 117. After de-interleaving the outputs of the parallel backend ADCs 614, 615, 616 we find an output at Fs, with improved anti-aliasing performance compared to only one backend ADC at Fs/N. An interleaved backend can in some examples be more economical to implement, compared to non-interleaved backend at Fs.

It has been found that time-interleaving backend ADC arrangements suffer from mismatch in the parallel arranged ADCs 614, 615, 616, in gain and bandwidth. The mismatch can lead to decreased performance. In a CT-P-ADC the first DAC 117, amplifier 112 and filter 113 "backend" path can be regarded as N different paths, that share the first DAC 117, amplifier 112 and filter 113, followed by a different backend "slice" running at Fs/N. The N paths but can have a slightly different overall transfer due to mismatch in parallel arranged ADCs 614, 615, 616.

The apparatus 120, 300 of this document could be used to find the gain and phase and bandwidth of each of the parallel backend ADC arrangements in one calibration. For example, if one of the "slices" of the backend, first ADC 614, 615, 616 has more gain, we can reproduce this added gain in a reconstruction filter 601, 602, 603 that corresponds to that "slice", cancelling the increase in noise floor that would be added due to the mismatch.

Thus, with reference to the Figure 7, which shows the determination of the transfer function of the (multipath in this example embodiment) signal processing device 102, one test signal is applied to the first DAC 117 and multiple responses, coming out of the multiple backend first ADCs 614, 615, 616, is received. Each of the responses is at Fs/N.

Thus, applying the test signal and receiving the output from each of the first ADCs 614, 615, 616 provides for determination of the calibration information representative of the transfer functions for each first ADCs 614, 615, 616. Thus, a corresponding digital filter 601, 602, 603 can be programmed. Filter 601, that implements the same transfer as from the input to the DAC to the output of backend slice 614, is found by applying the test signal and providing the output of ADC 614 to apparatus of figure 3. Filter 602 is found by applying the same test signal and providing the output of ADC 615 to the apparatus of figure 3. Filter 603 is found by applying the same test signal and the output of ADC 616 is provided to the apparatus of figure 3.

Alternatively, the backend slices 614, 615 and 616 can be implemented with adjustable gain and bandwidth, with an adjustment range that could compensate the largest expected deviation of the default gain and bandwidth. Using the proposed configuration of Fig. 7 the N slices can be characterized, where any deviation between the paths is caused by the differences between the backend slices, since the DAC 117, amplifier 112 and filter 113 is common to all N paths.

Based upon the differences the slices can be adjusted until they are equal, removing the non-ideality. After the adjustment, the reconstruction filters 601, 602 and 603 can be implemented with a single, non-interleaved filter, operating at Fs.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An apparatus for determining a transfer function of a signal processing device, the apparatus comprising at least one detector comprising:

   a first input configured to receive a first signal;
   a second input configured to receive a response signal comprising a response of the signal processing device to the first signal;
   a signal modification block;
   a comparison block;
   a decimation block;
   wherein the comparison-block comprises a phase comparator and an amplitude comparator, wherein the phase comparator is configured to provide a first output indicative of a phase difference between the first signal, after a correction has been applied by the signal modification block and decimation has been applied by the decimation block, and the response signal and the amplitude comparator is configured to provide a second output indicative of an amplitude difference between the first signal, after a correction has been applied by the signal modification block and decimation has been applied by the decimation block, and the response signal;

a feedback loop including the signal modification block, wherein the signal modification block is coupled to the first input and the decimation block is coupled in series between the signal modification block and the comparison block and the signal modification block is configured to selectively apply the correction to the first signal, and wherein the feedback loop is configured to, based on the output of the phase comparator and the output of the amplitude comparator, provide a feedback control signal to control the signal modification block to reduce the phase difference indicated by the first output and the amplitude difference indicated by the second output; and

wherein the at least one detector is configured to determine, at least, the feedback control signal at a first frequency and the feedback control signal at a second frequency, different to the first frequency and, therefrom, determine calibration information representative of the transfer function for programming of a digital filter.

2. The apparatus of claim 1, wherein the apparatus incudes an interpolation-block, wherein the interpolation-block is configured to interpolate at least between the first frequency and the second frequency to determine the calibration information for programming of the transfer function of said digital filter based on at least a first frequency domain sample, wherein the detector is configured to determine the first frequency domain sample by determining a discrete Fourier transform of the feedback control signal at the first frequency; and a second frequency domain sample, wherein the detector is configured to determine the second frequency domain sample by determining a discrete Fourier transform of the feedback control signal at the second frequency, and wherein
the interpolation-block is configured to apply an interpolation algorithm that determines, based on the first frequency domain sample and the second frequency domain sample and by interpolation, the calibration information.

3. The apparatus of claim 1 or claim 2, wherein the signal processing device comprises a continuous pipeline ADC comprising a first ADC configured to output the response of the signal processing device to the first signal and a second ADC, wherein the second ADC is configured to operate at a sampling frequency $F_s$ and the first ADC is configured to operate at a sampling frequency $F_s/N$ and wherein the decimation block of the apparatus is configured to output a decimated signal at the sampling frequency of the first ADC.

4. The apparatus of claim 3, wherein N is an integer odd number.

5. The apparatus of claim 3 or claim 4, wherein the apparatus is configured to provide for generation of the first signal, wherein the first signal comprises a square wave.

6. The apparatus of claim 5, wherein

(a) the apparatus is configured to provide for generation of the first signal having a fundamental frequency of Fs/M wherein M > N;
(b) the apparatus is configured to provide for generation of the first signal, comprising a square wave having a fundamental frequency of Fs/M wherein M > N mixed with another square wave of fundamental frequency Fs/P.

7. The apparatus of claim 5, wherein the frequencies used to generate the square waves are configured such that harmonics of the square wave do not fold on top of each other when decimated to Fs/N by said decimation block.

8. The apparatus of any preceding claim, wherein the at least one detector and interpolation block are configured to: determine an interpolation between the first and second frequency domain samples or an inverse discrete Fourier transform of the at least first and second frequency domain samples.

9. The apparatus of any preceding claim, wherein said at least one detector comprises a first detector and a second detector, wherein the first detector is configured to determine the first frequency domain sample and the second detector is configured to determine the second frequency domain sample in parallel, and wherein the interpolation-block is configured to receive the frequency domain sample from the first detector and the frequency domain sample from the second detector.

10. The apparatus of any preceding claim, wherein the signal modification block is a controllable finite-impulse-response, FIR, filter.

11. A combination of the apparatus of any preceding claim and a continuous-time, pipeline ADC, CT-P-ADC, wherein the CT-P-ADC comprises the digital filter, and the signal processing device comprises at least part of the CT-P-ADC, and the CT-P-ADC or apparatus is configured to program the digital filter based on the calibration information.

12. The combination of claim 11, wherein the CT-P-ADC comprises a time interleaving backend comprising a plurality of selectable ADCs in parallel wherein one of:

(a) each of the plurality of ADCs has adjustable gain and bandwidth and wherein determination of the calibration information includes the combination being configured to determine gain and bandwidth mismatch differences between each of the plurality of ADCs and provide for adjustment of the adjustable gain and bandwidth to remove the mismatch; and
(b) wherein the determination of the calibration information includes the combination being configured to determine calibration information for each of the plurality of ADCs for programming of a respective a digital filter for each of the plurality of ADCs.

13. The combination of claim 11, wherein the CT-P-ADC comprises:

a CT-P-ADC input to receive an analogue signal,
a branch node configured to provide the analogue signal to a first path and a second path,
wherein the first path comprises at least a continuous time all-pass filter, CTAPF; a difference block having a first input configured to receive the output of the CTAPF and a second input, and configured to output a difference between signals at the first input and the second input; an amplifier configured to receive the output of the difference block and provide an output; a low-pass-filter configured to receive the output of the amplifier and provide an output; and a, first ADC configured to receive the output of the low-pass-filter and provide the response signal to the second input;
wherein the second path comprises a second ADC configured to receive the analogue signal via the branch node and the digital filter configured to receive the output of the second ADC and a second decimation block;
wherein the CT-P-ADC comprises a summation block configured to provide an output of the CT-P-ADC based on a summation of the output of the first ADC from the first path and the output of the second decimation block of the second path;
wherein the CT-P-ADC comprises a first DAC configured to receive the output of the second ADC and provide a digitised output to the second input of the difference block.

14. The combination of claim 11, wherein the digital filter comprises a polyphase filter.

15. A method for an apparatus for determining a transfer function of a signal processing device, the apparatus comprising at least one detector comprising a signal modification block; a comparison block; and a decimation block for performing the method of:

receiving, at a first input, a first signal;
receiving, at a second input, a response signal comprising a response of the signal processing device to the first signal;
making a comparison by a comparison-block comprising one or both of a phase comparator and an amplitude comparator, of one or both of the phase and amplitude of the first signal and the response signal;
outputting, by the phase comparator, a first output indicative of a phase difference between the first signal after correction applied by the signal modification block and decimation applied by the decimation block, and the response signal;
outputting, by the amplitude comparator, a second output indicative of an amplitude difference between the first signal after correction applied by the signal modification block and decimation applied by the decimation block, and the response signal;
providing feedback, wherein a feedback loop including the signal modification block and the decimation block, and wherein the signal modification block is coupled to the first input and the decimation block is coupled in series between the signal modification block and the comparison block, is configured to, based on the output of the phase comparator and the output of the amplitude comparator, generate a feedback control signal to control the signal modification block to reduce the phase difference indicated by the first output and the amplitude difference indicated by the second output; and
determining, at least, the feedback control signal at a first frequency and the feedback control signal at a second frequency, different to the first frequency.

**Amended claims in accordance with Rule 137(2) EPC.**

1. An apparatus for determining a transfer function of a signal processing device (102), the apparatus comprising at least one detector (120, 301) comprising:

   a first input (110, 302) configured to receive a first signal;
   a second input (111, 303) configured to receive a response signal comprising a response of the signal processing device (102) to the first signal;
   a signal modification block (306);
   a comparison block (304);
   a decimation block (309);
   wherein the comparison-block (304) comprises a phase comparator (401) and an amplitude comparator (402), wherein the phase comparator is configured to provide a first output indicative of a phase difference between the first signal, after a correction has been applied by the signal modification block (306) and decimation has been applied by the decimation block, and the response signal and the amplitude comparator is configured to provide a second output indicative of an amplitude difference between the first signal, after a correction has been applied by the signal modification block and decimation has been applied by the decimation block, and the response signal;
   a feedback loop (305) including the signal modification block (306), wherein the signal modification block is coupled to the first input (110, 302) and the decimation block (309) is coupled in series between the signal modification block and the comparison block (304) and the signal modification block is configured to selectively apply the correction to the first signal, and wherein the feedback loop is configured to, based on the output of the phase comparator (401) and the output of the amplitude comparator (402), provide a feedback control signal (307) to control the signal modification block to reduce the phase difference indicated by the first output and the amplitude difference indicated by the second output;
   wherein the at least one detector (120, 301) is configured to determine, at least, the feedback control signal (307) at a first frequency and the feedback control signal at a second frequency, different to the first frequency and, therefrom, determine calibration information representative of the transfer function for programming of a digital filter (101),
   wherein the signal processing device (102) comprises a continuous pipeline ADC comprising a first ADC (114) configured to output the response of the signal processing device to the first signal and a second ADC (115), wherein the second ADC is configured to operate at a sampling frequency $F_s$ and the first ADC is configured to operate at a sampling frequency $F_s/N$ and wherein the decimation block (309) of the apparatus is configured to output a decimated signal at the sampling frequency of the first ADC; and
   wherein the first signal comprises a signal with content at one or more specific frequencies of interest, single tones or signals containing multiple tones, such that no two or more tones fold to the same frequency of interest after decimation.

2. The apparatus of claim 1, wherein the apparatus incudes an interpolation-block (308), wherein the interpolation-block is configured to interpolate at least between the first frequency and the second frequency to determine the calibration information for programming of the transfer function of said digital filter (101) based on at least a first frequency domain sample, wherein the detector (120, 301) is configured to determine the first frequency domain sample by determining a discrete Fourier transform of the feedback control signal (307) at the first frequency; and a second frequency domain sample, wherein the detector is configured to determine the second frequency domain sample by determining a discrete Fourier transform of the feedback control signal at the second frequency, and wherein the interpolation-block (308) is configured to apply an interpolation algorithm that determines, based on the first frequency domain sample and the second frequency domain sample and by interpolation, the calibration information.

3. The apparatus of claim 1 or claim 2, wherein N is an integer odd number.

4. The apparatus of any preceding claim, wherein the apparatus is configured to provide for generation of the first signal, wherein the first signal comprises a square wave.

5. The apparatus of claim 4, wherein

   (a) the apparatus is configured to provide for generation of the first signal having a fundamental frequency of Fs/M wherein M > N; or
   (b) the apparatus is configured to provide for generation of the first signal, comprising a square wave having a fundamental frequency of Fs/M wherein M > N mixed with another square wave of fundamental frequency Fs/P.

6. The apparatus of any preceding claim, wherein the at least one detector (120, 301) and interpolation block (308) are configured to:
determine an interpolation between the first and second frequency domain samples or an inverse discrete Fourier transform of the at least first and second frequency domain samples.

7. The apparatus of any preceding claim, wherein said at least one detector (120, 301) comprises a first detector and a second detector, wherein the first detector is configured to determine the first frequency domain sample and the second detector is configured to determine the second frequency domain sample in parallel, and wherein the interpolation-block (308) is configured to receive the frequency domain sample from the first detector and the frequency domain sample from the second detector.

8. The apparatus of any preceding claim, wherein the signal modification block (306) is a controllable finite-impulse-response, FIR, filter.

9. A combination of the apparatus of any preceding claim and a continuoustime, pipeline ADC, CT-P-ADC, wherein the CT-P-ADC comprises the digital filter (101), and the signal processing device (102) comprises at least part of the CT-P-ADC, and the CT-P-ADC or apparatus is configured to program the digital filter based on the calibration information.

10. The combination of claim 9, wherein the CT-P-ADC comprises a time interleaving backend comprising a plurality of selectable ADCs (614, 615, 616) in parallel wherein one of:

(a) each of the plurality of ADCs (614, 615, 616) has adjustable gain and bandwidth and wherein determination of the calibration information includes the combination being configured to determine gain and bandwidth mismatch differences between each of the plurality of ADCs and provide for adjustment of the adjustable gain and bandwidth to remove the mismatch; and
(b) wherein the determination of the calibration information includes the combination being configured to determine calibration information for each of the plurality of ADCs (614, 615, 616) for programming of a respective a digital filter (601, 602, 603) for each of the plurality of ADCs.

11. The combination of claim 9, wherein the CT-P-ADC comprises:

a CT-P-ADC input (103) to receive an analogue signal,
a branch node (104) configured to provide the analogue signal to a first path (105) and a second path (106),
wherein the first path (105) comprises at least a continuous time all-pass filter, CTAPF (107); a difference block (108) having a first input (110) configured to receive the output of the CTAPF and a second input (111), and configured to output a difference between signals at the first input and the second input; an amplifier (112) configured to receive the output of the difference block and provide an output; a low-pass-filter (113) configured to receive the output of the amplifier and provide an output; and a, first ADC (114) configured to receive the output of the low-pass-filter and provide the response signal to the second input;
wherein the second path (106) comprises a second ADC (115) configured to receive the analogue signal via the branch node (104) and the digital filter (101) configured to receive the output of the second ADC and a second decimation block (122);
wherein the CT-P-ADC comprises a summation block (116) configured to provide an output of the CT-P-ADC based on a summation of the output of the first ADC (114) from the first path (105) and the output of the second decimation block (122) of the second path (106);
wherein the CT-P-ADC comprises a first DAC (117) configured to receive the output of the second ADC (115) and provide a digitised output to the second input (111) of the difference block (108).

12. The combination of claim 9, wherein the digital filter (101) comprises a polyphase filter.

13. A method for an apparatus for determining a transfer function of a signal processing device, the apparatus comprising at least one detector comprising a signal modification block; a comparison block; and a decimation block for performing the method of:

receiving (501), at a first input, a first signal;
receiving (502), at a second input, a response signal comprising a response of the signal processing device to the first signal;
making (503) a comparison by a comparison-block comprising a phase comparator and an amplitude comparator, of the phase and amplitude of the first signal and the response signal;

outputting (504), by the phase comparator, a first output indicative of a phase difference between the first signal after correction applied by the signal modification block and decimation applied by the decimation block, and the response signal;

outputting (505), by the amplitude comparator, a second output indicative of an amplitude difference between the first signal after correction applied by the signal modification block and decimation applied by the decimation block, and the response signal;

providing feedback (506), wherein a feedback loop (305) including the signal modification block and the decimation block, and wherein the signal modification block is coupled to the first input and the decimation block is coupled in series between the signal modification block and the comparison block, is configured to, based on the output of the phase comparator and the output of the amplitude comparator, generate a feedback control signal to control the signal modification block to reduce the phase difference indicated by the first output and the amplitude difference indicated by the second output; and

determining (507), at least, the feedback control signal at a first frequency and the feedback control signal at a second frequency, different to the first frequency; wherein

the signal processing device comprises a continuous pipeline ADC comprising a first ADC configured to output the response of the signal processing device to the first signal and a second ADC, wherein the second ADC is configured to operate at a sampling frequency $F_s$ and the first ADC is configured to operate at a sampling frequency $F_s/N$ and wherein the decimation block of the apparatus is configured to output a decimated signal at the sampling frequency of the first ADC; and

the first signal comprises a signal with content at one or more specific frequencies of interest, single tones or signals containing multiple tones, such that no two or more tones fold to the same frequency of interest after decimation.

Fig. 1

Fig. 2

Fig. 3

Fig. 4

Fig. 5

EP 4 622 110 A1

Fig. 6

Fig. 7

22

| | Europäisches Patentamt European Patent Office Office européen des brevets | **EUROPEAN SEARCH REPORT** | **Application Number** EP 24 16 5506 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KSHIRSAGAR PARAG ET AL: "Implementation and Evaluation of Online System Identification of Electromechanical Systems Using Adaptive Filters", IEEE TRANSACTIONS ON INDUSTRY APPLICATIONS, IEEE SERVICE CENTER, PISCATAWAY, NJ, US, vol. 52, no. 3, 8 January 2016 (2016-01-08), pages 2306-2314, XP011610291, ISSN: 0093-9994, DOI: 10.1109/TIA.2016.2515994 [retrieved on 2016-05-18] * abstract * * figures 2a,3 * * Section II.A, II.C * ----- | 1-15 | INV. H03M1/08 H03M1/16 |
| A | PAVAN SHANTHI ET AL: "Analysis and Design of Wideband Filtering ADCs Using Continuous-Time Pipelining", IEEE JOURNAL OF SOLID-STATE CIRCUITS, IEEE, USA, vol. 59, no. 1, 1 June 2023 (2023-06-01), pages 268-281, XP011957529, ISSN: 0018-9200, DOI: 10.1109/JSSC.2023.3276633 [retrieved on 2023-06-01] * Sections III.B, IV * ----- -/-- | 1-15 | TECHNICAL FIELDS SEARCHED (IPC) H03M |

The present search report has been drawn up for all claims

| Place of search | Date of completion of the search | Examiner |
|---|---|---|
| The Hague | 12 September 2024 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| | Europäisches Patentamt European Patent Office Office européen des brevets | **EUROPEAN SEARCH REPORT** | **Application Number** EP 24 16 5506 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BASAVARAJ NISHANTH ET AL: "Simplified Simulation and Measurement of the Signal Transfer Function of a Continuous-Time Pipelined Analog-to-Digital Converter", IEEE TRANSACTIONS ON CIRCUITS AND SYSTEMS II: EXPRESS BRIEFS, vol. 69, no. 10, 2 June 2022 (2022-06-02), pages 3993-3997, XP093204401, USA ISSN: 1549-7747, DOI: 10.1109/TCSII.2022.3179772 * the whole document * ----- | 1-15 | |
| | | | **TECHNICAL FIELDS SEARCHED (IPC)** |

The present search report has been drawn up for all claims

| Place of search | Date of completion of the search | Examiner |
|---|---|---|
| The Hague | 12 September 2024 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10447523 B2